(19) Europäisches Patentamt
European Patent Office
Office européen des brevets

(11) Numéro de publication: **0 061 784**
**A1**

(12)

# DEMANDE DE BREVET EUROPEEN

(21) Numéro de dépôt: **82103936.9**

(22) Date de dépôt: **23.05.80**

(51) Int. Cl.³: **H 01 S 3/19**

(30) Priorité: **01.06.79 FR 7914177**

(43) Date de publication de la demande:
**06.10.82 Bulletin 82/40**

(84) Etats contractants désignés:
**DE GB IT NL**

(60) Numéro de publication de la demande initiale en application de l'article 76 CBE: **0 020 254**

(71) Demandeur: **THOMSON-CSF**
**173, Boulevard Haussmann**
**F-75360 Paris Cedex 08(FR)**

(72) Inventeur: **Carballes, Jean-Claude**
**THOMSON-CSF SCPI 173, bld Haussmann**
**F-75360 Paris Cedex 08(FR)**

(72) Inventeur: **Bodere, Alain**
**THOMSON-CSF SCPI 173, bld Haussmann**
**F-75360 Paris Cedex 08(FR)**

(72) Inventeur: **Macaire, Alain**
**THOMSON-CSF SCPI 173, bld Haussmann**
**F-75360 Paris Cedex 08(FR)**

(54) **Diode laser à émission localisée.**

(57) L'invention concerne les diodes électroluminescentes de type laser. Elle a pour but d'optimiser le rendement, la qualité de l'émission pour une puissance maximale, enfin de diminuer le coût de fabrication.

Dans une diode laser comportant une mince couche photoémissive (30, figure 2) encadrée par des couches (20 et 40) de confinement électrique contribuant à la propagation du mode fondamental transverse de l'onde lumineuse, la couche 40, la plus éloignée du substrat, présente une structure mésa, facile à réaliser, dont la plateforme centrale supporte une couche semiconductrice 50 fortement dopée, ce qui facilite la localisation de l'émission lumineuse au centre de la diode, par concentration de l'injection de courant électrique.

Application aux émetteurs optoélectroniques.

FIG. 2

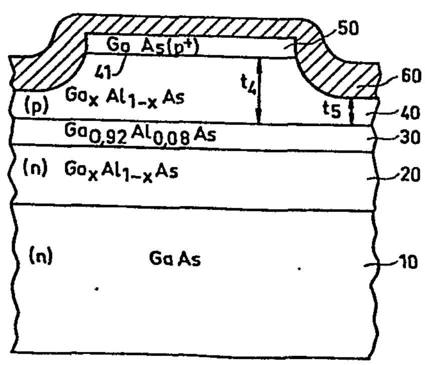


EP 0 061 784 A1

Croydon Printing Company Ltd.

# DIODE LASER A EMISSION LOCALISEE

L'invention concerne les diodes électroluminescentes de type laser à émission localisée.

On connait différentes structures de telles diodes dans lesquelles l'émission lumineuse est localisée, notamment la structure dite "en ruban".

En général, dans ces structures, le fonctionnement sur un mode fondamental unique de l'onde lumineuse n'est possible que si l'on ne dépasse pas un certain seuil de puissance lumineuse de l'ordre de 10 milliwatts.

Parmi les structures en ruban, la structure CSP (de l'anglais : channel stripe planar) où le ruban est enterré dans une structure à face supérieure plane, permet d'obtenir une puissance lumineuse supérieure à 10 mW en mode fondamental. Toutefois, cette structure est difficile à réaliser, par suite de particularités qui apparaîtront dans la description sommaire ci-après : sur la face supérieure d'un substrat 1, (figure 1) de Ga As dopé n, a été gravé un canal 11 dans le matériau même de ce substrat. Ensuite, par épitaxie en phase liquide, on a déposé successivement :

- une couche 2 de $Ga_{0,65}$ $Al_{0,35}$ As dopé n, dont l'épaisseur est telle qu'elle fait disparaître le canal 11 et, en outre, présente une face supérieure 21 pratiquement plane ; elle comporte, par conséquent, une zone centrale A d'épaisseur $t_1$ et deux zones latérales B d'épaisseur $t_2$ :

- une couche 3 de $Ga_{0,92}$ $Al_{0,08}$ As, dont l'épais-

seur e est de l'ordre du dixième de micron ;

- une couche 4 de $Ga_{0,65}$ $Al_{0,35}$ As dopé p et une couche 5 de Ga As dopé $p^+$ dans lesquelles on a diffusé du zinc renforçant le dopage p dans une zone 50 d'injection localisée du courant de polarisation. Cette zone pénètre dans la couche 4 sans atteindre la couche 3 ;

- une couche métallique 6 formant contact ohmique.

La localisation de l'émission lumineuse provient de la combinaison de deux effets. D'une part, l'injection de courant est localisée au centre de la structure. D'autre part, la couche 3, source de l'émission, est d'épaisseur suffisamment faible pour que le guidage optique ne soit pas confiné à cette couche. On sait que, dans ce cas, il y a couplage par onde évanescente avec les couches 2 et 4 dites de confinement. Les épaisseurs $t_1$ et $t_2$ ont été choisies pour qu'il en soit ainsi, et dans ces conditions, l'absorption optique induite par le couplage dans le substrat 1 est très importante dans la zone B et négligeable dans la zone A.

La réalisation du canal 11, tout en respectant la planéité de l'interface des couches 3 et 4 est d'une grande difficulté technologique.

L'invention vise à remédier à ces difficultés. Elle donne une structure relativement simple et capable d'émettre plus de 10 mW de puissance lumineuse sur le mode fondamental transverse. En outre, par la délocalisation de l'onde lumineuse en épaisseur on évite l'inconvénient de dégradation des faces clivées de la diode laser, lorsque la densité photonique dépasse une certaine valeur dans les faces situées aux deux extrémités du ruban.

Dans une réalisation de diode laser, proposée par le brevet français N° 76 14 163, publié sous le N° 2 351 504, on favorise l'injection de courant par une couche "en ruban" localisée au centre de la structure, en arséniure de gallium fortement dopé, que l'on recouvre d'une couche métallique

débordant de part et d'autre du ruban sur la couche de confinement de la diode laser, couche réalisée en Ga Al As. Par suite de la grande résistance électrique entre métal et Ga Al As, les lignes de courant sont localisées dans le ruban d'arséniure de gallium. Toutefois, on remarque l'absence de véritable structure mésa.

L'invention vise au contraire l'obtention d'une structure mésa entamant nettement la couche de confinement dans les zones latérales.

La diode laser selon l'invention présente une structure comportant un substrat semiconducteur présentant un premier type de conductivité et comportant une première électrode de fonctionnement, une première couche semiconductrice (de confinement électrique en contact avec le substrat, présentant le même type de conductivité que celui-ci, une couche semiconductrice photoémissive, une deuxième couche semiconductrice de confinement électrique présentant le type opposé de conductivité, supportant une deuxième électrode, la deuxième couche de confinement comprenant une zone centrale à travers laquelle le passage du courant électrique est rendu plus facile et des zones latérales à travers lesquelles il est rendu moin facile.

Elle est caractérisée en ce que la couche semiconductrice photoémissive présente une épaisseur de l'ordre de 0,1 micron, que la structure mésa est telle que la deuxième couche de confinement est amincie dans les zones latérales jusqu'à présenter une épaisseur de l'ordre du micron, que la zone centrale de la deuxième couche de confinement est recouverte d'une couche semiconductrice de même type de conductivité que la deuxième couche de confinement, et qu'enfin une couche métallique est déposée directement par évaporation sous vide sur la surface de la zone centrale et des zones latérales.

L'invention sera mieux comprise, et d'autres caractéristiques apparaîtront, au moyen de la description qui suit et des dessins qui l'accompagnent, parmi lesquels :

- la figure 1 représente une structure connue de diode laser ;

- la figure 2 représente une réalisation de l'invention ;

La structure de la figure 1 a été décrite ci-avant.

La structure de la figure 2, conforme à l'invention, constitue une exemple, parmi d'autres, de celle-ci. On y trouve un substrat 10 en monocristal d'arseniure de gallium dopé n et une succession de couches obtenues par croissance épitaxiale du substrat, échelonnées comme suit:

a) une couche 20 d'un composé ternaire $Ga_xAL_{1-x}As$ dopé n, où x ne dépasse pas 0,8 ; son épaisseur $t'_2$ est de l'ordre de 2 microns ;

b) une couche 30 non dopée, d'épaisseur assez faible par exemple 0,1 micron pour que le guidage optique n'y soit pas confiné, d'un composé analogue dans lequel x est compris entre les valeurs 0,8 et 1 ;

c) une couche 40 d'un composé ternaire $Ga_xAl_{1-x}As$ dopé p, où x ne dépasse pas 0,8 ; x peut avoir, par exemple la même valeur que dans le composé de la couche 20. Cette couche, initialement d'épaisseur $t_4$ (par exemple de l'ordre de 2 microns) a subi ensuite une attaque mésa qui lui donne, de part et d'autre de la région centrale, une épaisseur réduite $t_5$ (par exemple de l'ordre de 1 micron). Cette attaque mésa peut être effectuée par voie chimique ou par tout autre moyen classique (bombardement ionique ou action d'un plasma) après qu'une partie 41 de la face supérieure ait reçu une couche de protection résistant à l'attaque mésa, et que l'on élimine par la suite.

d) une couche 50 de Ga As dopé $p^+$, limitée à la partie 41 ; l'épaisseur de cette couche, de l'ordre de 1 000 angströms, sert à faciliter l'injection de courant dans la diode ; la partie 41 présente une largeur de 5 à 7 microns et une longueur de 100 à 500 microns ;

e) un dépôt métallique uniforme 60, recouvrant à la fois la partie 41 et la portion à nu de la couche 40, est déposée par un moyen classique, tel que l'évaporation de métal sous vide. Elle comporte, par exemple, une succession de couches (non représentées individuellement) de titane, de platine et d'or.

Dans cette structure la localisation de l'émission lumineuse est obtenue grâce à la localisation de l'injection de courant au droit de la couche 50. En effet, la résistance de contact entre la couche métallique 60 et la couche 50 de Ga As dopé $p^+$ est très faible (de l'ordre de $10^{-5}$ ohm/$cm^2$) ; au contraire, elle est très importante entre la couche 60 et la couche 40 de Ga Al As en raison de son plus faible dopage et de l'existence d'une couche d'oxyde naissant à la surface de cette couche 40. L'injection de courant se fait donc préférentiellement dans le ruban constitué par la couche 50

de Ga As dopé $p^+$.

En outre, le bon fonctionnement de la diode laser est favorisé par le couplage des couches de confinement avec une couche émissive d'épaisseur assez faible pour créer la délocalisation de l'onde lumineuse et éviter le défaut de dégradation des faces clivées.

Les composés de gallium, d'aluminium et d'arsenic peuvent être remplacés par des composés de gallium, d'arsenic, d'indium, de phosphore et éventuellement d'aluminium.

L'invention comprend également les émetteurs d'optoélectronique utilisant une diode laser selon l'invention.

REVENDICATIONS

1. Diode laser à émission localisée, dont la structure comporte un substrat semiconducteur (10) présentant un premier type de conductivité et comportant une première électrode de fonctionnement, une première couche semiconductrice (20) de confinement électrique en contact avec le substrat (10) présentant le même type de conductivité, une couche semiconductrice (30) photoémissive, une deuxième couche semiconductrice (40) de confinement électrique présentant le type opposé de conductivité, supportant une deuxième électrode (60), la deuxième couche (40) de confinement comprenant une zone centrale à travers laquelle le passage du courant électrique est rendu plus facile et des zones latérales à travers lesquelles il est rendu moins facile, caractérisée en ce que la couche semiconductrice (30) photoémissive présente une épaisseur de l'ordre de 0,1 micron, que la structure mésa est telle que la deuxième couche semiconductrice (40) de confinement électrique est amincie dans les zones latérales jusqu'à présenter une épaisseur de l'ordre du micron, que la zone centrale de la deuxième couche (40) de confinement électrique est recouverte d'une couche semiconductrice (50) de même type de conductivité que la deuxième couche (40) de confinement, et qu'enfin une couche métallique est déposée directement par évaporation sous vide sur la surface de la zone centrale et des zones latérales.

2. Diode laser suivant la revendication 1, caractérisée en ce que le substrat étant en arséniure de gallium dopé n, les deux couches de confinement électrique sont constituées par des composés de formule $Ga_xAl_{1-x}$ As, dans laquelle x ne dépasse pas 0,8, la première couche de confinement étant dopée n et la deuxième dopée p, la couche photoémissive étant constituée par un composé de formule :

$$Ga_y\ Al_{1-y}\ As$$

où l'on a :

$$0,8 \leq y \leq 1$$

3. Diode laser suivant la revendication 3, caractérisée en ce qu'elle comporte une couche de Ga As dopé $p^+$ au contact de la couche de confinement dopée p.

4. Diode laser suivant l'une quelconque des revendications 1 à 3, caractérisée en ce que les matériaux semiconducteurs constituant la diode comportent, outre le gallium et l'arsenic, de l'indium et du phosphore.

Fig. 1

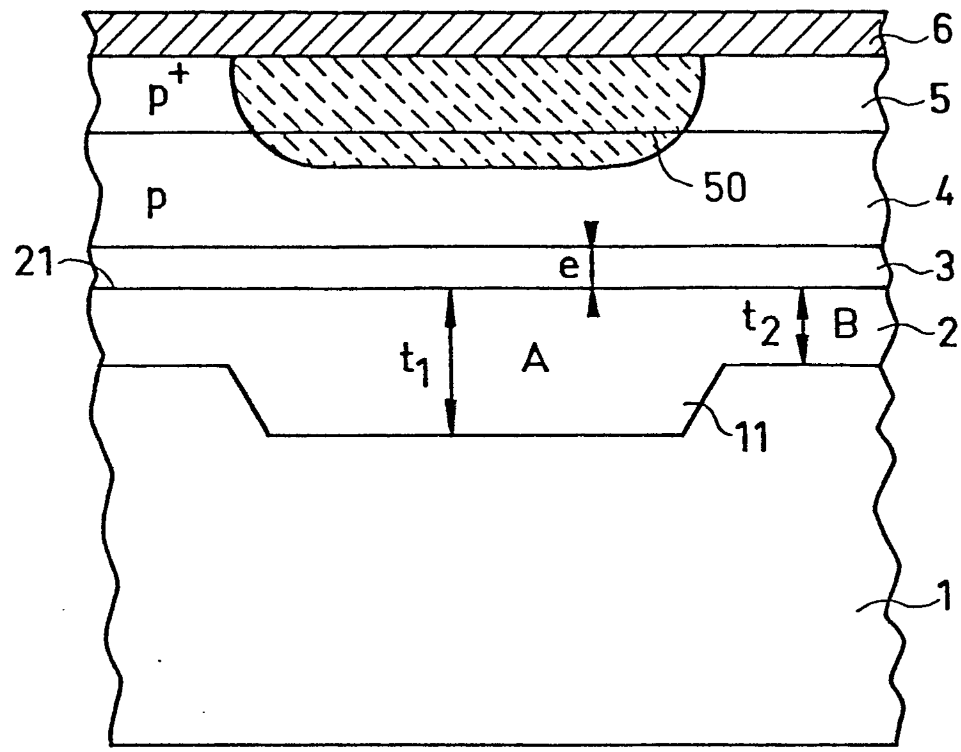

6
p+
5
50
p
4
21
e
3
t2
B
2
t1
A
11
1


Fig. 2

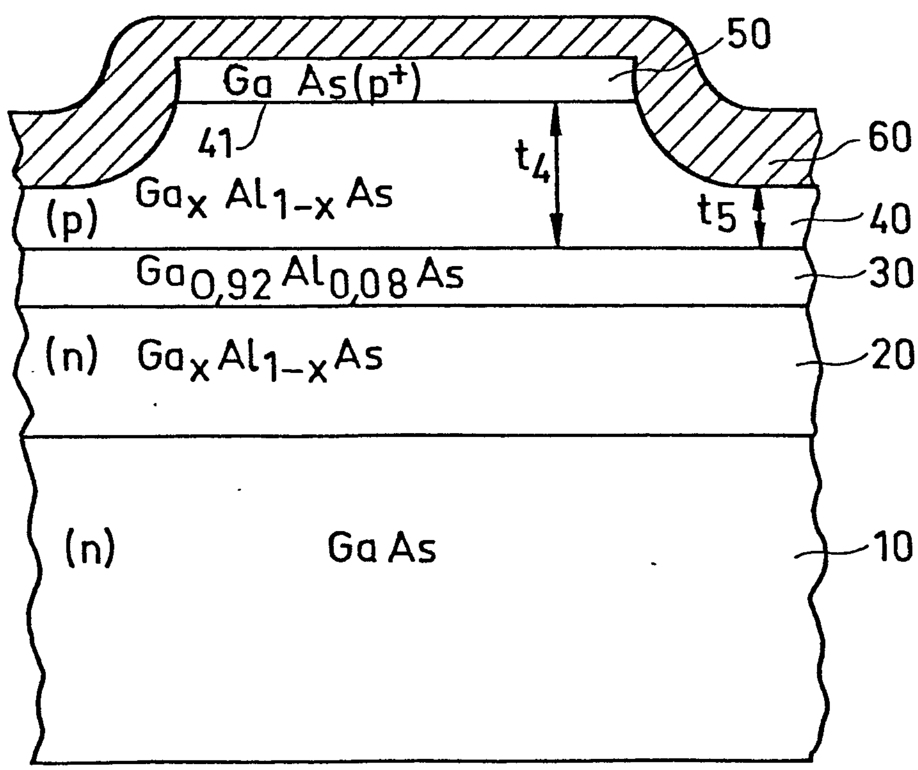

50
Ga As(p+)
41
t4
60
Gax Al1-x As
(p)
t5
40
Ga0,92 Al0,08 As
30
(n) Gax Al1-x As
20
(n)
Ga As
10

Office européen des brevets

**0061784**

Numéro de la demande

# RAPPORT DE RECHERCHE EUROPEENNE

EP 82 10 3936

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int Cl. 3) |
|---|---|---|---|
| X,Y | DE - A - 2 701 102 (HITACHI)<br>* pages 7-9,11; figure 3; revendication 1 *<br>-- | 1,2,4 | H 01 S 3/19 |
| Y | FR - A - 2 386 166 (I.S.E.)<br>* page 7; lignes 25-38; page 8, lignes 1-28; figure 3 *<br>-- | 1 | |
| A | FR - A - 2 297 507 (I.S.E.)<br>* page 4, lignes 21-27; figure 1; revendications 1,2 *<br>------ | 1 | |
| | | | DOMAINES TECHNIQUES RECHERCHES (Int. Cl. 3) |
| | | | H 01 S 3/19 |

Le présent rapport de recherche a été établi pour toutes les revendications

| Lieu de la recherche | Date d'achèvement de la recherche | Examinateur |
|---|---|---|
| La Haye | 28-06-1982 | ARMITANO-GRIVEL |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire
T : théorie ou principe à la base de l'invention
E : document de brevet antérieur, mais publié à la date de dépôt ou après cette date
D : cité dans la demande
L : cité pour d'autres raisons
& : membre de la même famille, document correspondant

OEB Form 1503.03.82